# EUROPEAN PATENT APPLICATION

(11) **EP 1 324 078 A2**
(43) Date of publication of application: **02.07.2003**
(21) Application number: 02026908.0
(22) Date of filing: 03.12.2002
(51) Int. Cl.: G02B 1/11, G02B 1/10, C08J 7/18

(54) **Hybrid film, antireflection film comprising it, optical product, and method for restoring the defogging property of hybrid film**

(30) Priority: 28.12.2001 JP 2001399609
(71) Applicant: HOYA CORPORATION, Shinjuku-ku, Tokyo 161-8525 (JP)
(72) Inventor: Shirakawa, Hiroshi, Hoya Corporation, Tokyo 161-8525 (JP); Mitsuishi, Takeshi, Hoya Corporation, Tokyo 161-8525 (JP); Shinde, Kenichi, Hoya Corporation, Tokyo 161-8525 (JP)
(74) Representative: HOFFMANN - EITLE

(57) **Abstract**

The present invention has the object to provide a hybrid film having good abrasion-resistant and defogging properties, an antireflection film comprising it, an optical product, and a method for restoring the defogging property of the hybrid film.

The above object is achieved by means of a hybrid film having a defogging property, which is obtained through vapor deposition of an organic compound having a hydrophilic group and a reactive group along with silicon dioxide or with silicon dioxide and aluminium oxide; an antireflection film to be formed on a substrate having the hybrid film as the outermost layer opposite to the substrate; an optical product comprising a plastic substrate and the antireflection film having the hybrid film; and a method for restoring the defogging property of the hybrid film of the optical product, which comprises washing of the hybrid film.

## Description

### [Technical Field to which the Invention Belongs]

The present invention relates to a hybrid film, an antireflection film comprising the hybrid film, an optical product, and a method for restoring the defogging property of the hybrid film. In particular, the invention relates to a hybrid film having good abrasion-resistance and defogging properties, an antireflection film comprising the hybrid film, an optical product, and a method for restoring the defogging property of the hybrid film.

### [Prior Art]

Heretofore optical products having an antireflection film formed thereon through inorganic vapor deposition are known. It is also known that the defogging property of the optical products of the type is not good.
To solve the problem, films having defogging and antireflection properties have been developed. For example, JP-T-10-510860 proposes a lens for glasses, which is obtained by coating a lens substrate with a coating composition that contains a porous inorganic oxide and a specific siloxane oligomer to form thereon a defogging and antireflection film.
However, the defogging lens proposed by the publication is not satisfactory in point of the abrasion resistance thereof, as compared with ordinary lenses for glasses that are coated with an antireflection film formed through ordinary vapor deposition. In addition, its antireflection property is not also satisfactory.

### [Problems that the Invention is to Solve]

The present invention has been made to solve the above problems, and its object is to provide a hybrid film having good abrasion-resistance and defogging properties, an antireflection film comprising the hybrid film, an optical product, and a method for restoring the defogging property of the hybrid film.

### [Means for Solving the Problems]

The present inventors have assiduously studied to solve the problems noted above, and, as a result, have found that, when a hybrid film formed through vapor deposition of an organic compound having a hydrophilic group and a reactive group along with silicon dioxide or with silicon dioxide and aluminium oxide is used, then an optical product having good abrasion-resistance and defogging properties can be obtained. For the purpose of the present invention, a hybrid film is considered to exhibit defogging properties if it exhibits a contact angle to water of less than 10 degrees. On the basis of this finding, the inventors have completed the present invention.
Specifically, the invention provides a hybrid film having a defogging property, which is obtained through vapor deposition of an organic compound having a hydrophilic group and a reactive group along with silicon dioxide or with silicon dioxide and aluminium oxide; an antireflection film to be formed on a substrate which comprises the hybrid film as the outermost layer of the antireflection film opposite to the substrate; an optical product which comprises a plastic substrate and the antireflection film having the hybrid film; and a method for restoring the defogging property of the hybrid film formed on the optical product, which comprises washing of the hybrid film of the optical product. The present invention also relates to methods for preparing the hybrid film specified above and for preparing optical products containing this hybrid film.

### [Modes of Carrying out the Invention]

The hybrid film of the invention is obtainable through vapor deposition of an organic compound having a hydrophilic group and a reactive group along with silicon dioxide or with silicon dioxide and aluminum oxide.
In that manner, the hybrid film of the invention contains a hydrophilic organic compound having a hydrophilic group in a layer of silicon dioxide or in a layer of silicon dioxide and aluminum oxide, in which the organic compound serves substantially as the hydrophilic group in a surface-active agent (surfactant) while, on the other hand, silicon oxide or the mixture of silicon oxide and aluminum oxide serves pseudo-actively as the hydrophobic group in a surfactant since its hydrophilicity is preferably lower than that of the organic compound. Accordingly, the hybrid film has substantially a property of a layer comprising a surfactant, and performs its defogging function.
Since the hybrid film is obtained through vapor deposition, its thickness is easy to control. In addition, since the hybrid film is crosslinked due to the addition of the reactive organic substance to the inorganic SiO₂ layer, its abrasion resistance is good.

Preferably, the hybrid film of the invention is obtained through vapor deposition according to an ion-assisted process in which the film is formed in a gaseous atmosphere. The ion-assisted process may be any known one, for example, as in M. Flindner et al's *Society of Vacuum Coaters,* Albuquerque, NM, USA, pp. 237-241, 1995. Regarding the preferred condition in the ion-assisted process, the accelerating voltage falls between 50 V and 150 V, and the accelerating current falls between 30 mA and 100 mA. The ionizing gas in the ion-assisted process is preferably argon (Ar) or a mixed gas of argon and oxygen in view of the reactivity and anti-oxidation in film formation therein.
In one preferred method of forming the hybrid film of the invention, one evaporation source of the organic compound, and another evaporation source of silicon oxide or silicon oxide and aluminium oxide are prepared, and these are simultaneously evaporated and deposited in vacuum. For controlling the evaporation and deposition rate thereof, the organic compound is preferably diluted with a solvent and impregnated into a biocolumn filter, and the filter with it is dried and used as the organic compound source. In this case, the solvent is not specifically limited. Preferably, however, dimethyl ether is used for amine-terminated organic compounds; ethyl acetate is used for epoxide-terminated organic compounds; trimethylethylsilane or diethyl ether is used for polysiloxane-type organic compounds of low polarity; and methanol is used for polyether-type organic compounds of high polarity.

In case where the organic compound to be used for forming the hybrid film of the invention is highly viscous and its boiling point is difficult or impossible to measure, it is preferred that a container of a porous material is provided for it and heated and the intended film is formed on a substrate through vapor deposition of the organic compound from the porous container. By dissolving the organic substance in a solvent and controlling the amount of the resulting solution, the thickness of the film to be formed may be controlled. In addition, the solution may be impregnated into a porous material and heated to control thereby the desired evaporation rate of the organic compound. More specifically, the porous material is preferably a sintered filter that may be prepared by sintering a metal powder of copper or the like of high thermal conductivity. The pore size of the porous material may fall generally between 40 and 200 µm, but preferably between 80 and 120 µm from the viewpoint of attaining a suitable evaporation rate of the organic compound. The temperature at which the container is heated generally falls between 200 and 300°C, but preferably between 200 and 240°C also from the viewpoint of attaining the suitable evaporation rate of the organic compound.
The heating device for use herein is not specifically limited. For example, employable are halogen heaters, resistance heaters, ceramic heaters, etc. Preferably, the heating device is equipped with a shutter system for controlling film formation. Also preferably, a jacket or the like for preventing the heated film-forming substance from scattering therearound to contaminate the substrate on which the film is formed, surrounds the heating device. For stable supply of the film-forming substance to the vapor deposition system, it is also desirable to set the biocolumn filter in an evaporation rate-controlling chamber with small holes formed in its wall. Regarding their shape, the small holes are preferably oval for ensuring better distribution orientation of the film-forming organic compound running through them.
In case where the organic compound has a relatively low viscosity (for example, at most 0.000015 m²/s (15 cst)) and its boiling point is easily determined, it may be put into an external tank heated at 50°C to 150°C and is evaporated and introduced into a vacuum chamber as a monomer gas, to form the intended film on a substrate. This is one preferred mode of film formation with the organic compound of that type. In this case, the flow rate of the organic compound from the external tank can be directly controlled, and the amount of the organic compound to be introduced into the vapor deposition system and the thickness of the film to be formed therein can be thereby controlled.

Preferably, the organic compound to be used for forming the hybrid film of the invention is characterized by a ratio of the relative molecular weight of the oxygen atoms contained in the organic compound divided by the molecular weight of the organic compound of from 18 to 40%, in order that the film formed of it can have a better defogging property. Also preferably, the number average molecular weight of the organic compound falls between 150 and 1500 g/mol.
Preferably, the content of the organic compound to be used in the hybrid film of the invention falls between 0.02 and 70 % by weight based on the total weight of the film.

The organic compound to be used in the hybrid film is preferably characterized by a chemical structure that falls within the scope of the general formulae (Ia) to (V) given below:

(Re-)ₙHy and (Re-L-)ₙHy (Ia) and (Ib)

Re(-Hy)ₘ and Re(-L-Hy)ₘ (IIa) and (IIb)

(Re-)ₙL(-Hy)ₘ (III)

(Re-)ₙHy(-L)ₒ (IV)

(L-)ₒ-Re(-Hy)ₘ (V)

wherein Re represents the reactive group and Hy represents the hydrophilic group and L represents a (non-hydrophilic, non-reactive) linker, which is a hydrocarbon moiety having 1 to 3 carbon atoms. The parameter n represents 1 or 2, m is 1 or more, and o is 1 or 2.

The hydrophilic group of the organic compound for forming the hybrid film of the invention is defined as follows: A group is to be considered as a hydrophilic group according to the present invention, if the solubility of a compound, which is derived from this group by attaching it to a methyl group, in water exceeds the minimum value of 90 %(v/V) at a temperature of 25°C.Preferred examples of the hydrophilic group include -SO₃H, -SO₃M, -OSO₃H, -OSO₃M, -COOM, -NR₃X, -COOH, -NH2, -CN, -OH, -NHCONH₂, -(OCH₂CH₂)ₚ-, -CH₂OCH₃, -OCH₃, -COOCH₃, -CS, and -CON (in these, R indicates an alkyl group having 1 to 2 carbon atoms, M indicates an alkali metal or NH₄, X indicates a halogen atom, and p indicates an integer of at least 1).
Preferably, the organic compound containing the hydrophilic group is a hydrophilic compound. Hydrophilicity is measured by the contact angle to water between a surface of a film, which is obtainable by curing the organic compound, and a drop of water. A compound is considered to be a hydrophilic compound if a film derived from this compound exhibits a contact angle to water lower than 10 degrees.
It is furthermore preferred if the organic compound exhibits a higher hydrophilicity as the silicon dioxide and/or the aluminum oxide. In this case, the individual hydrophilicities are also determined and compared on the basis of the contact angles between films of the pure substances and a drop of water, as indicated above.
The reactive group of the organic compound for forming the hybrid film of the invention is defined as a group which is capable of reacting with itself or with the silicon dioxide and/or the aluminum oxide present in the hybrid layer. Preferred examples of the reactive group include an epoxy group, a methacrylic group, an acrylic group, an amino group, a thiol group, a trialkoxysilyl group having from 3 to 15 carbon atoms, and a hydroxyl group.

Preferably, the organic compound for forming the hybrid film of the invention is any of a compound having a polyether backbone chain and a reactive group at both ends thereof, a compound having a chain of repetitive units of hydroxymethylene and having a reactive group at both ends thereof, or a compound having a chain of repetitive units of carboxymethylene and having a reactive group at both ends thereof.

The compound having a polyether backbone chain and a reactive group at both ends thereof includes those of the following general formula (1): 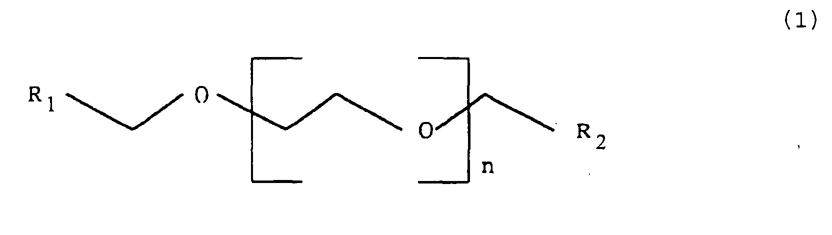 wherein R₁ and R₂ each independently represents an epoxy group, a methacrylic group, an acrylic group, an amino group, a thiol group, a trialkoxysilyl group having from 3 to 15 carbon atoms, a hydroxyl group, or an organic group that contains at least one selected from these groups; the organic group containing at least one of the groups listed above is preferably composed of a hydrocarbon group having 1 to 3 carbon atoms, to which one or more of the functional groups listed above are attached; n indicates an integer of at least 1 which provides the number average molecular weight of the compound falling between 150 and 1500 g/mol.

The compound having a chain of repetitive units of hydroxymethylene and having a reactive group at both ends thereof includes those of the following general formula (2); and the compound having a chain of repetitive units of carboxymethylene and having a reactive group at both ends thereof includes those of the following general formula (3) : 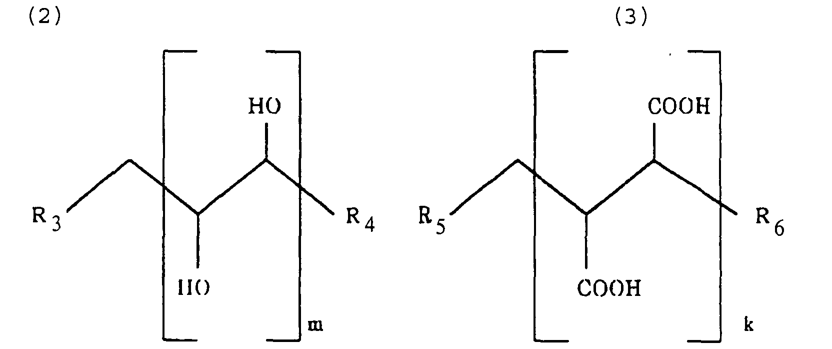 wherein R₃, R₄, R₅ and R₆ each independently represents an epoxy group, a methacrylic group, an acrylic group, an amino group, a thiol group, a trialkoxysilyl group having from 3 to 15 carbon atoms, a hydroxyl group, or an organic group that contains at least one group selected from these; m and k each indicates an integer of at least 2 which provides the number average molecular weight of the compound falling between 225 and 1500 g/mol.
It is furthermore within the scope of the present invention to form hybrid layers using a combination of more than one of the organic compounds specified in the previous paragraphs.

If desired, a crosslinking agent may be added to the organic compound that forms the hybrid film of the invention. For the crosslinking agent, usable are quaternary silanes such as tetraalkoxysilanes having 1 to 2 carbon atoms and tetraaminosilanes. Preferably, the amount of the crosslinking agent to be added thereto falls between 1 and 20 % by weight of the organic compound.

The hybrid film of the invention may be used in a multi-layered antireflection film, serving as a low-refractivity layer thereof. Specifically, in a multi-layered antireflection film formed on a substrate, the hybrid film may be the outermost layer opposite to the substrate. Having this constitution, the antireflection film and the optical product comprising it may have good abrasion resistance and good defogging and antireflection properties.
The thickness of the hybrid film of the invention is not specifically limited but preferably falls between 5 and 100 nm. In case where the hybrid film serves as the outermost low-reflectivity layer of a multi-layered antireflection film, its optical thickness may be on a level with the optical thickness (λ/4) of any known low-reflectivity layer of silicon dioxide or the like that may be in such a multi-layered antireflection film, wherein λ represents the wavelength of the light applied. In that case, the refractive index of the hybrid film preferably falls between 1.42 and 1.48.

As the case may be, the hybrid film of the invention may be nearest to the substrate for ensuring good impact resistance of the coated substrate. When the hybrid film is positioned nearest to the substrate to that effect, an undercoat layer may be provided between the hybrid film and the substrate for enhancing the adhesiveness therebetween. The undercoat layer may be made of at least one metal having a catalytic action in forming the hybrid film thereon, for example, selected from nickel (Ni), silver (Ag), platinum (Pt), niobium (Nb) and titanium (Ti). More preferably, the undercoat layer is a metal layer of niobium that ensures better impact resistance of the coated substrate. If an undercoat layer of metal is provided between the substrate and the hybrid film, the impact resistance of the coated substrate will be improved.
For ensuring the adhesiveness between the plastic substrate and the undercoat layer and for unifying the initial condition of the hybrid film to be formed through vapor deposition on the undercoat layer, the substrate may be pretreated with an ion gun before forming the undercoat layer. The ionizing gas for the ion gun pretreatment may be any of oxygen or argon (Ar). Regarding the preferred range of the ion gun output, the accelerating voltage may fall between 50 V and 200 V and the accelerating current may fall between 50 mA and 150 mA for better adhesiveness between the two and for better abrasion resistance of the coated substrate.

Except for the layer of the hybrid film of the invention, the other layers of the antireflection film are preferably formed through vapor deposition. If desired, for example, they may be formed through physical vapor deposition (PVD), chemical vapor deposition (CVD), sputtering, ion plating or plasma CVD.
Except for the layer of the hybrid film, the other layers of the antireflection film are not specifically limited. For better antireflection effect thereof, however, the antireflection film preferably comprises metal oxides, more preferably comprises a low-refractivity layer of SiO₂ or a mixture of SiO₂ and Al₂O₃, and a high-refractivity layer of Nb₂O₅ or TiO₂.

The optical product of the invention comprises a plastic substrate and an antireflection film having the hybrid film of the invention, formed on the plastic substrate.
The material of the plastic substrate for the optical product of the invention is not specifically limited, including, for example, methyl methacrylate homopolymers, copolymers of methyl methacrylate with at least one other monomer, diethylene glycol bisallylcarbonate homopolymers, copolymers of diethylene glycol bisallylcarbonate with at least one other monomer, sulfur-containing copolymers, halogen-containing copolymers, polycarbonates, polystyrenes, polyvinyl chlorides, unsaturated polyesters, polyethylene terephthalates, polyurethanes, and polythiourethanes.

The optical product of the invention may have a hard coat film between the plastic substrate and the antireflection film having the hybrid film, or between the plastic substrate and the undercoat layer.
For the hard coat film, generally used is a composition that comprises metal oxide colloid particles and an organosilicon compound of the following general formula (I):

(R₇)ₐ(R₈)_{b}Si(OR₉)_{4-(a+b)} (I)

wherein R₇ and R₈ each independently represents an organic group selected from an alkyl group having from 1 to 8 carbon atoms, an alkenyl group having from 2 to 8 carbon atoms, an aryl group having from 6 to 8 carbon atoms, an acyl group having from 1 to 8 carbon atoms, a halogen atom, an glycidoxy group, an epoxy group, an amino group, a mercapto group, a methacryloxy group and a cyano group; R₉ represents an organic group selected from an alkyl group having from 1 to 8 carbon atoms, an acyl group having from 1 to 8 carbon atoms and an aryl group having from 6 to 8 carbon atoms; a and b each independently indicates an integer of 0 or 1.

The metal oxide colloid particles include, for example, those of tungsten oxide (WO₃), zinc oxide (ZnO), silicon oxide (SiO₂), aluminium oxide (Al₂O₃), titanium oxide (TiO₂), zirconium oxide (ZrO₂), tin oxide (SnO₂), beryllium oxide (BeO) and antimony oxide (Sb₂O₅). One or more different types of such metal oxides may be used either singly or as combined for the colloid particles.

Preferred examples of the organosilicon compound of formula (I) include methyl silicate, ethyl silicate, n-propyl silicate, i-propyl silicate, n-butyl silicate, sec-butyl silicate, tert-butyl silicate, tetraacetoxysilane, methyltrimethoxysilane, methyltriethoxysilane, methyltripropoxysilane, methyltriacetoxysilane, methyltributoxysilane, methyltripropoxysilane, methyltriamyloxysilane, methyltriphenoxysilane, methyltribenzyloxysilane, methyltriphenethyloxysilane, glycidoxymethyltrimethoxysilane, glycidoxymethyltriethoxysilane, α-glycidoxyethyltriethoxysilane, β-glycidoxyethyltrimethoxysilane, β-glycidoxyethyltriethoxysilane, α-glycidoxypropyltrimethoxysilane, α-glycidoxypropyltriethoxysilane, β-glycidoxypropyltrimethoxysilane, β-glycidoxypropyltriethoxysilane, γ-glycidoxypropyltrimethoxysilane, γ-glycidoxypropyltriethoxysilane, γ-glycidoxypropyltripropoxysilane, γ-glycidoxypropyltributoxysilane, γ-glycidoxypropyltriphenoxysilane, α-glycidoxybutyltrimethoxysilane, α-glycidoxybutyltriethoxysilane, β-glycidoxybutyltrimethoxysilane, β-glycidoxybutyltriethoxysilane, γ-glycidoxybutyltrimethoxysilane, γ-glycidoxybutyltriethoxysilane, δ-glycidoxybutyltrimethoxysilane, δ-glycidoxybutyltriethoxysilane, (3,4-epoxycyclohexyl)methyltrimethoxysilane, (3,4-epoxycyclohexyl)methyltriethoxysilane, β-(3,4-epoxycyclohexyl)ethyltrimethoxysilane, β-(3,4-epoxycyclohexyl)ethyltriethoxysilane, β-(3,4-epoxycyclohexyl)ethyltripropoxysilane, β-(3,4-epoxycyclohexyl)ethyltributoxysilane, β-(3,4-epoxycyclohexyl)ethyltriphenoxysilane, γ-(3,4-epoxycyclohexyl)propyltrimethoxysilane, γ-(3,4-epoxycyclohexyl)propyltriethoxysilane, δ-(3,4-epoxycyclohexyl)butyltrimethoxysilane, δ-(3,4-epoxycyclohexyl)butyltriethoxysilane, glycidoxymethylmethyldimethoxysilane, glycidoxymethylmethyldiethoxysilane, α-glycidoxyethylmethyldimethoxysilane, α-glycidoxyethylmethyldiethoxysilane, β-glycidoxyethylmethyldimethoxysilane, β-glycidoxyethylmethyldiethoxysilane, α-glycidoxypropylmethyldimethoxysilane, α-glycidoxypropylmethyldiethoxysilane, β-glycidoxypropylmethyldimethoxysilane, β-glycidoxypropylmethyldiethoxysilane, γ-glycidoxypropylmethyldimethoxysilane, γ-glycidoxypropylmethyldiethoxysilane, γ-glycidoxypropylmethyldipropoxysilane, γ-glycidoxypropylmethyldibutoxysilane, γ-glycidoxypropylmethyldiphenoxysilane, γ-glycidoxypropylethyldimethoxysilane, γ-glycidoxypropylethyldiethoxysilane, γ-glycidoxypropylvinyldimethoxysilane, γ-glycidoxypropylvinyldiethoxysilane, γ-glycidoxypropylphenyldimethoxysilane, γ-glycidoxypropylphenyldiethoxysilane, ethyltrimethoxysilane, ethyltriethoxysilane, vinyltrimethoxysilane, vinyltriacetoxysilane, vinyltrimethoxyethoxysilane, phenyltrimethoxysilane, phenyltriethoxysilane, phenyltriacetoxysilane, γ-chloropropyltrimethoxysilane, γ-chloropropyltriethoxysilane, γ-chloropropyltriacetoxysilane, 3,3,3-trifluoropropyltrimethoxysilane, γ-methacryloxypropyltrimethoxysilane, γ-mercaptopropyltrimethoxysilane, γ-mercaptopropyltriethoxysilane, β-cyanoethyltriethoxysilane, chloromethyltrimethoxysilane, chloromethyltriethoxysilane, N-(β-aminoethyl)-γ-aminopropyltrimethoxysilane, N-(β-aminoethyl)-γ-aminopropylmethyldimethoxysilane, γ-aminopropylmethyldimethoxysilane, N-(β-aminoethyl)-γ-aminopropyltriethoxysilane, N-(β-aminoethyl)-γ-aminopropylmethyldiethoxysilane, dimethyldimethoxysilane, phenylmethyldimethoxysilane, dimethyldiethoxysilane, phenylmethyldiethoxysilane, γ-chloropropylmethyldimethoxysilane, γ-chloropropylmethyldiethoxysilane, dimethyldiacetoxysilane, γ-methacryloxypropylmethyldimethoxysilane, γ-methacryloxypropylmethyldiethoxysilane, γ-mercaptopropylmethyldimethoxysilane, γ-mercaptopropylmethyldiethoxysilane, methylvinyldimethoxysilane, and methylvinyldiethoxysilane.

The hard coat film is formed, for example, by applying its coating composition onto the substrate. The coating composition may be prepared in any ordinary manner. If desired, the coating composition may contain a curing catalyst and any of various organic solvents and surfactants for improving the wettability of the substrate with the composition to thereby improve the surface smoothness of the hard coat film formed of the composition. Preferred curing catalysts include amines such as allylamine, ethylamine, etc.; various acids and bases including Lewis acids and Lewis bases, salts or metal salts with organic carboxylic acids, chromic acid, hypochlorous acid, boric acid, perchloric acid, bromic acid, selenious acid, thiosulfuric acid, orthosilicic acid, thiocyanic acid, nitrous acid, aluminic acid, carbonic acid or the like; as well as metal alkoxides with aluminium, zirconium, titanium and the like, and their metal chelate compounds. If further desired, it may contain any of UV absorbents, antioxidants, light stabilizers and anti-aging agents so long as they do not cause any negative influences on the coating composition and on the physical properties of the hard coat film formed from the composition.
For applying the coating composition onto the substrate, employable is any ordinary method of dipping, spin coating, or spraying. In view of the face accuracy of the film formed of the composition (i.e. the evenness of the surface of the film), especially preferred is dipping or spin coating.
Having been applied to the substrate, the composition is cured by drying it in hot air or by exposing it to active energy rays. In general, it is cured in hot air at 70 to 200°C, preferably at 90 to 150°C. For the active energy rays, far-infrared rays are preferred as the damage of the film by heat is suppressed at a low degree.

The optical product of the invention has a defogging property, but its defogging property is not maintained permanently. When the defogging property of the optical product has deteriorated, it can be restored by washing the hybrid film of the optical product.
Preferably, the film is washed through a plasma treatment. The plasma treatment comprises plasma discharge that leads to molecular dissociation to give excited molecules, radicals and ions, to which the intended subject is exposed. The time for plasma irradiation to the film is not specifically limited herein, but preferably falls between 5 seconds and 60 seconds.

### [Examples]

The invention is described in more detail with reference to the following Examples, which, however, are not intended to restrict the scope of the invention as defined by the appended claims.
The physical properties of the optical products obtained in the Examples were evaluated as follows:

### (1) Luminous Transmittance:

Using Hitachi spectrophotometer U-3410, the luminous transmittance, Y, of samples of plastic lenses having an antireflection film formed on both surfaces was measured.

### (2) Luminous Reflectance:

Using the Hitachi spectrophotometer U-3410, the luminous reflectance, Y, of samples of plastic lenses having an antireflection film formed on both surfaces was measured.

### (3) Film Adhesiveness:

Using a cutting tool, the surface of each plastic lens was cut to have 100 cross-cuts of 1 mm x 1 mm each. An adhesive tape, Cellotape (Trade name,sold by Nichiban Corp.) was stuck on its cross-cut area, and rapidly peeled off. The number of the cross-cuts having remained on the lens was counted and shown in the following Tables, in which (number of cross-cuts remained)/100 indicates the film adhesiveness of the plastic lenses tested.

### (4) Abrasion Resistance:

The surface of each plastic lens was rubbed with standard steel wool #0000 produced by Japan Steel Wool Corp., under a load of 1 kgf/cm² applied thereto. After 10 strokes of rubbing, the surface condition of each plastic lens was visually checked. The plastic lenses thus tested were evaluated according to the following criteria:
UA: Scratched little.
A: A few thin scratch marks found.
B: Many thin scratch marks and a few thick scratch marks found.
C: Many thin and thick scratch marks found.
D: Almost completely peeled.

### (5) Defogging property:

The samples were stored in a refrigerator at 5°C for 20 minutes, then immediately transferred into a thermostat having a humidity of 90 % and a temperature of 40°C and left therein for 10 seconds. With that, each sample was checked for the degree of haze, and evaluated according to the following criteria:
Level 4: Wearing the lens, one can read a book.
Level 3: Wearing the lens, one can walk in the daytime.
Level 2: Wearing the lens, one can see somehow the scene around it.
Level 1: Wearing the lens, one cannot see at all the scene around it.
Samples of Levels 1 and 2 are not considered to have a defogging property.

### (6) Contact Angle to Water

The contact angle to water of the surface of a plastic lens was measured by K12 Automatic surface tension balance (made by Kruess Corp.), which used Wilhelmy's method.

### (7) Content of Organic Substance in the Hybrid Layer

The content of the organic substance in the hybrid layer in the film was determined by previously grasping the refractive indices of the inorganic substance and the organic substance, and measuring the film thickness of the hybrid layer and the reflectance thereof. The content of the organic substance in the hybrid layer can be determined using the refractive index of the hybrid layer by means of interpolation from the refractive index of a layer consisting of the organic substance and the refractive index of a layer consisting of the inorganic substance as a basis.

### Examples 1 and 2:

90 parts by weight of colloidal silica (Snowtex-40 from Nissan Chemical), 81.6 parts by weight of methyltrimethoxysilane (organosilicon compound), 176 parts by weight of γ-glycidoxypropyltrimethoxysilane (organosilicon compound), 2.0 parts by weight of 0.5 N hydrochloric acid, 20 parts by weight of acetic acid, and 90 parts by weight of water were put into a glass reactor, and stirred at room temperature for 8 hours. Then, this was left at room temperature for 16 hours to be a hydrolyzed solution. To this were added 120 parts by weight of isopropyl alcohol, 120 parts by weight of n-butyl alcohol, 16 parts by weight of aluminium acetylacetone, 0.2 parts by weight of silicone surfactant (polyalkylene oxide methylsiloxane copolymer type, trade name: Y 7006, produced by Nippon Unicar Company Ltd.), and 0.1 parts by weight of UV absorbent (2-(2-hydroxy-4-octyloxyphenyl)-2H-benzotriazol; trade name: Seesorb 707R, produced by Shiporro Corp.). Then, this was further stirred at room temperature for 8 hours, and then aged at room temperature for 24 hours to be a coating solution.
A plastic lens substrate (made of diethylene glycol bisallyl carbonate, and having a refractive index of 1.50, a center thickness of 2.0 mm and a power of 0.00) was pretreated with an aqueous alkali solution. This was dipped in the coating solution. After having been thus dipped therein, this was taken out at a pulling rate of 20 cm/min. Then, this was heated at 120°C for 2 hours. In that manner, the plastic lens substrate was coated with a hard coat film (hard coat layer A). Next, this was subjected to ion gun pretreatment with Ar gas. The ion accelerating voltage and the ion exposure time for the pretreatment are shown in the Table mentioned below.
Next, under the conditions shown in Table 1, a multi-layered antireflection film composed of 1st to 7th layers was formed on the hard coat layer A to obtain plastic lenses.
As indicated in Table 1, the organic compound having a hydrophilic group and a reactive group used in Example 1 is an organic substance A (polyethylene glycol glycidyl ether, E-400 from Nippon Yushi Corp.); and that used in Example 2 is an organic substance B (polyethylene glycol monoacrylate, AE-400 from Nippon Yushi Corp.).
In forming the multi-layered antireflection film, its 7th layer of hybrid film was formed according to an ion-assisted process using an ion gun. In this process for it, Ar gas was used, the accelerating voltage was 70 V and the accelerating current was 70 mA. The organic substance A was put in an external tank heated at 80°C and fed into a vapor deposition chamber having a reduced pressure of 5 x 10⁻⁵ Torr, while the inorganic component was supplied simultaneously thereinto through evaporation by means of an electron gun to form a hybrid film thereon. The condition of the evaporation and deposition of the inorganic substance and the organic substance was so controlled that they are almost simultaneously deposited on the substrate as bideposition.
The plastic lenses thus obtained were evaluated according to the test methods (1) to (5) mentioned above, and the results are shown in Table 1. In the Table, λ indicates the wavelength of light applied to the samples, and λ = 500 nm. The refractive index of the hybrid layer is measured at λ = 500 nm.

### Example 3:

A hard coat layer A was formed on the substrate in the same manner as in Example 1. Next, under the conditions shown in Table 2, a multi-layered antireflection film composed of 1st to 7th layers was formed on the hard coat layer A to obtain a plastic lens.
As indicated in Table 2, the organic compound having a hydrophilic group and a reactive group used in Example 3 is an organic substance C (N-(3-trimethoxysilylpropyl)gluconamide from Chisso Corp.).
In forming the multi-layered antireflection film, the hybrid film as the 7th layer was formed according to an ion-assisted process using an ion gun. In this process, Ar gas was used, the accelerating voltage was 80 V and the accelerating current was 80 mA. The organic substance C was dissolved in a solvent, ethyl acetate, to prepare a 50 % solution thereof. 0.5 ml of the solution was impregnated into a biocolumn (stainless steel filter of 18 mm diameter and 3 mm thickness, having a pore size of from 80 to 100 µm). The biocolumn was set in a deposition chamber having a vacuum degree of 6.7 x 10⁻³ Pa (5 x 10⁻⁵ Torr) and heated at 150 to 200°C therein, while the inorganic component was evaporated simultaneously by means of an ion gun to form a hybrid film. The condition of the evaporation and deposition of the inorganic substance and the organic substance was so controlled that they are almost simultaneously deposited on the substrate as bideposition.
The plastic lens thus obtained was evaluated according to the test methods (1) to (5) mentioned above, and the results are shown in Table 2. In the Table, λ indicates the wavelength of light applied to the samples, and λ = 500 nm. The refractive index of the hybrid layer is measured at λ = 500 nm.
Layers, which were produced without an ion assisted process, are indicated in the following tables by the sign '-' in the column 'Ion gun setting'. These layers were deposited through conventional vapor deposition.

**Table 1-1**

| | Example 1 | | Example 2 | |
|---|---|---|---|---|
| Plastic Lens Substrate | diethylene glycol bisallyl carbonate | | diethylene glycol bisallyl carbonate | |
| Hard Coat Layer | Layer A | | Layer A | |
| Setting for lon Gun Pretreatment Gas used | accelerating voltage 200 V, accelerating current 100 mA Ar | | accelerating voltage 200 V, accelerating current 100 mA Ar | |
| | Type of Film, Film Thickness | lon gun Setting | Type of Film, Film Thickness | Ion gun Setting |
| 1st Layer | SiO₂+Al₂O₃, 0.25 λ layer refractive index, 1.486 | 100 V, 70 mA Ar gas | SiO₂+Al₂O₃, 0.25 λ layer refractive index, 1.486 | 100 V, 70 mA Ar gas |
| 2nd Layer | Nb₂O₅, 0.038 λ | 350 V, 130 mA O₂/Ar, 8/2 | Nb₂O₅, 0.041 λ | 350 V, 130 mA O₂/Ar, 8/2 |
| 3rd Layer | SiO₂+Al₂O₃, 0.121 λ layer refractive index, 1.486 | - | SiO₂+Al₂O₃, 0.12 λ layer refractive index, 1.486 | 100 V, 70 mA Ar gas |
| 4th Layer | Nb₂O₅, 0.164 λ | 350 V, 130 mA O₂/Ar, 8/2 | Nb₂O₅, 0.170 λ | 350 V, 130 mA O₂/Ar, 8/2 |
| 5th Layer | SiO₂+Al₂O₃, 0.059 λ | - | SiO₂+Al₂O₃, 0.055 λ | 100 V, 70 mA |
| | layer refractive index, 1.486 | | layer refractive index, 1.486 | Ar gas |
| 6th Layer | Nb₂O₅, 0.180 λ | 350 V, 130 mA O₂/Ar, 8/2 | Nb₂O₅, 0.187 λ | 350 V, 130 mA O₂/Ar, 8/2 |
| 7th Layer | SiO₂+Al₂O+organic substance A, 0.276 λ layer refractive index, 1.465 SiO₂+Al₂O₃ = 1.486 content of organic substance, about 10 to 15 wt.% | 70 V, 70 mA Ar gas | SiO₂+Al₂O₃+organic substance B, 0.266 λ layer refractive index, 1.462 SiO₂+Al₂O₃ = 1.486 content of organic substance, about 10 to 15 wt.% | 100 V, 70 mA Ar gas |
| Organic Substance used | A: polyethylene glycol glycidyl ether, Nippon Yushi's E-400 | | B: polyethylene glycol monoacrylate, Nippon Yushi's AE-400 | |

**Table 1-2**

| Evaluation of Plastic Lens Properties | | |
|---|---|---|
| | Example 1 | Example 2 |
| Luminous Reflectance, Y % | 0.81 % | 0.72 % |
| Luminous Transmittance, Y % | 99.0 % | 99.1 % |
| Film Adhesiveness | 100/100 | 100/100 |
| Abrasion Resistance | UA | UA |
| Defogging property | 4 | 4 |

**Table 2-1**

| | Example 3 | |
|---|---|---|
| Plastic Lens Substrate | diethylene glycol bisallyl carbonate | |
| Hard Coat Layer | Layer A | |
| Setting for lon Gun Pretreatment Gas used | accelerating voltage 200 V, accelerating current 100 mA Ar | |
| | Type of Film, Film Thickness | Ion gun Setting |
| 1st Layer | 0.25 λ SiO₂+Al₂O₃ = 1.486 | 100 V, 70 mA Ar gas |
| 2nd Layer | Nb₂O₅, 0.038 λ | - |
| 3rd Layer | SiO₂+Al₂O₃ 0.121 λ | - |
| 4th Layer | Nb₂O₅, 0.164 λ | - |
| 5th Layer | SiO₂+Al₂O₃ 0.059 λ | - |
| 6th Layer | Nb₂O₅, 0.180 λ | - |
| 7th Layer | SiO₂+Al₂O₃+organic substance C, 0.267 λ layer refractive index, 1.465 SiO₂+Al₂O₃ = 1.486 organic substance C = 1.427, content of organic substance, about 6 to 10 wt.% | 80 V, 80 mA Ar gas |
| Organic Substance used | C: N-(3-trimethoxysilylpropyl)gluconamide (from Chisso) | |

[Table 4]

**Table 2-2**

| Evaluation of Plastic Lens Properties | |
|---|---|
| | Example 3 |
| Luminous Reflectance, Y % | 0.81 % |
| Luminous Transmittance, Y % | 99.0 % |
| Film Adhesiveness | 100/100 |
| Abrasion Resistance | UA |
| Defogging property | 4 |

As can be seen in Tables 1 and 2, the plastic lenses of Examples 1 to 3 all have an extremely small luminous reflectance of from 0.72 to 0.81 % and have a large luminance transmittance of from 99.0 to 99.1 %. In addition, their film adhesiveness, abrasion resistance and defogging property are all good.
It is noted that the contact angles to water of lenses in Examples 1 to 3 were as follows: The contact angle measured for Example 1 was 5 degrees, for Example 2 it was 4 degrees and for Example 3, it was 5 degrees.

### Example 4:

The antireflection film of each defogging plastic lens produced in Examples 1 to 3, in which the outermost layer of the antireflection film is a hybrid film of the invention, was rubbed with chamois leather under a load of 100 g applied thereto. After 200 strokes of rubbing, the defogging property of each lens lowered to the level 2 and the contact angles to water of lenses of Examples 1 to 3 were 16 degrees (Example 1), 15 degrees (Example 2) and 16 degrees (Example 3). With that, the lenses were stood in the chamber of a laboratory plasma generator, and the chamber was then degassed to have a reduced pressure of 133 Pa (1 Torr). Next, air was introduced into the chamber at a flow rate of 70 cc/min (in terms of the volume at 25°C), and the lenses therein were subjected to air plasma treatment with an RF (radiofrequency) power 200 W applied thereto for 15 seconds. Through the treatment, all the plastic lenses of Examples 1 to 3 were restored to their original condition in point of their defogging property, not damaged at all in point of their other properties. Thus restored, the defogging property of all these lenses increased to the level 4 and the contact angles to water of lenses of Examples 1 to 3 were 5 degrees (Example 1), 4 degrees (Example 2) and 5 degrees (Example 3).

### [Advantages of the Invention]

As described in detail hereinabove, the hybrid film of the invention is transparent, its abrasion resistance and defogging property are good, and its reflectance is low. This demonstrates the usability of the hybrid film in the antireflection film. Accordingly, the hybrid film is favorably used in antireflection films and optical products. In addition, even when the defogging property of the hybrid film is deteriorated, it can be readily restored to its original condition according to the method for restoring the defogging property of the hybrid film of the invention. The above Examples 1 to 4 describe preferred embodiments of the present invention, the scope of which being defined by the appended claims. Further preferred embodiments of the present invention can be derived from the above Examples 1 to 4 by combining individual layers of different examples in a manner that is in accordance with the present invention.

## Claims

1. A hybrid film having a defogging property, which is obtainable through vapor deposition of an organic compound having a hydrophilic group and a reactive group along with silicon dioxide or with silicon dioxide and aluminium oxide.

2. The hybrid film as claimed in claim 1, which is obtainable in an ion-assisted process.

3. The hybrid film as claimed in claim 1, wherein the organic compound is a hydrophilic compound, and the hydrophilicity of silicon dioxide or that of a combination of silicon dioxide and aluminium oxide is lower than the hydrophilicity of the organic compound.

4. The hybrid film as claimed in any one of claims 1 to 3, wherein the ratio of the relative molecular weight of the oxygen atoms contained in the organic compound divided by the molecular weight of the organic compound is from 18 to 40%.

5. The hybrid film as claimed in any one of claims 1 to 4, wherein the content of the organic compound in the hybrid film is from 0.02 to 70 % by weight on the basis of the hybrid film.

6. The hybrid film as claimed in any one of claims 1 to 5, wherein the number average molecular weight of the organic compound falls between 150 and 1500 g/mol.

7. The hybrid film as claimed in any one of claims 1 to 6, wherein the organic compound is a compound having a polyether backbone chain and a reactive group at both ends of the polyether backbone chain.

8. The hybrid film as claimed in any one of claims 1 to 7, wherein the reactive group is selected from the group consisting of an epoxy group, a methacrylic group, an acrylic group, an amino group, a thiol group, a trialkoxysilyl group having from 3 to 15 carbon atoms, and a hydroxyl group.

9. The hybrid film as claimed in claim 7, wherein the organic compound is represented by the following general formula (1): 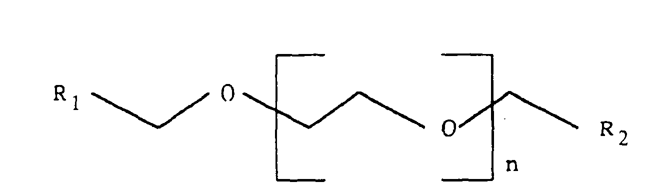 wherein R₁ and R₂ each independently represents an epoxy group, a methacrylic group, an acrylic group, an amino group, a thiol group, a trialkoxysilyl group having from 3 to 15 carbon atoms, a hydroxyl group, or an organic group that contains at least one selected from these groups; n indicates an integer of at least 1 which provides the number average molecular weight of the compound falling between 150 and 1500 g/mol.

10. The hybrid film as claimed in any one of claims 1 to 6, wherein the organic compound has a chain of repetitive units of hydroxymethylene or carboxymethylene, and has a reactive group at both ends thereof.

11. The hybrid film as claimed in claim 10, wherein the reactive group is an epoxy group, a methacrylic group, an acrylic group, an amino group, a thiol group, a trialkoxysilyl group having from 3 to 15 carbon atoms, or a hydroxyl group.

12. The hybrid film as claimed in claim 10, wherein the organic compound is represented by the following general formula (2) or (3): [Formula 2] 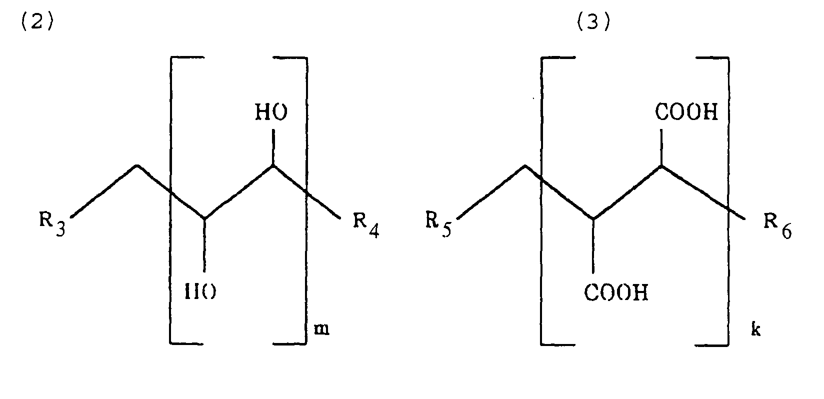 wherein R₃, R₄, R₅ and R₆ each independently represents an epoxy group, a methacrylic group, an acrylic group, an amino group, a thiol group, a trialkoxysilyl group having from 3 to 15 carbon atoms, a hydroxyl group, or an organic group that contains at least one group selected from these; m and k each indicates an integer of at least 2 which provides the number average molecular weight of the compound falling between 225 and 1500 g/mol.

13. The hybrid film as claimed in any one of claims 1 to 12, which has a refractive index of from 1.42 to 1.48.

14. The hybrid film as claimed in any one of claims 1 to 13, which has a thickness of from 5 nm to 100 nm.

15. An antireflection film, which comprises the hybrid film of any one of claims 1 to 14 as the outermost layer of the antireflection film.

16. An optical product which comprises a plastic substrate and the antireflection film according to claim 15, wherein the hybrid film of any one of claims 1 to 14 forming the outermost layer of the antireflection film is located opposite to the substrate.

17. The optical product as claimed in claim 16, which further comprises a hard coat film between the plastic substrate and the antireflection film having the hybrid film.

18. A method for restoring the defogging property of the hybrid film formed on the optical product of claim 16 or 17, which comprises washing of the hybrid film of the optical product.

19. The method for restoring the defogging property of the hybrid film as claimed in claim 18, wherein washing of hybrid film is carried out by means of a plasma treatment.

20. Method for preparing the hybrid film according to any one of claims 1 to 14, comprising the vapor deposition of an organic compound having a hydrophilic group and a reactive group along with silicon dioxide or with silicon dioxide and aluminium oxide.

21. Method for preparing the optical product according to claim 16 or 17, comprising the formation of the hybrid film according to any one of claims 1 to 14 as the outermost layer of the antireflection film that is located opposite to the substrate.
